# EUROPEAN PATENT SPECIFICATION

(11) **EP 1 717 355 B1**
(45) Date of publication and mention of the grant of the patent: **20.11.2013**
(21) Application number: 05709283.5
(22) Date of filing: 24.01.2005
(51) Int. Cl.: C30B 29/06, C30B 15/00

(54) **PRODUCTION APPARATUS AND PROCESS FOR PRODUCING SILICON SINGLE CRYSTAL AND SILICON WAFER**
HERSTELLUNGSVORRICHTUNG UND HERSTELLUNGSVERFAHREN FÜR SILICIUMEINKRISTALL UND SILICIUMWAFER
APPAREIL DE PRODUCTION ET PROCESSUS DE PRODUCTION DE MONOCRISTAUX DE SILICIUM ET DE PLAQUE DE SILICIUM

(30) Priority: 02.02.2004 JP 2004025923
(43) Date of publication of application: 02.11.2006
(73) Proprietor: Shin-Etsu Handotai Co., Ltd., Tokyo (JP)
(72) Inventor: IIDA, Makoto Shirakawa R&D Ctr.,Shinin-Etsu Hand., Fukushima 9618061 (JP); IMAI, Toshihiko Shirakawa R&D Ctr.,Shinin-Etsu H., Fukushima 9618061 (JP); Sato, Katsuichi Shirakawa R&D Ctr.,Shinin-Etsu H., Fukushima 9618061 (JP); IWABUCHI, Miho Shirakawa R&D Ctr.,Shinin-Etsu Ha., Fukushima 9618061 (JP); KATO, Masahiro Isobe R&D Ctr.,Shin-Etsu Handotai, Annaka-shi, Gunma 3790196 (JP)
(74) Representative: Wibbelmann, Jobst
(86) International application number: PCT/JP2005/000839
(87) International publication number: WO 2005/073439

(56) References cited:
- EP-A- 0 691 423
- EP-A- 1 182 281
- WO-A1-01/81661
- JP-A- 3 080 193
- JP-A- 4 108 683
- JP-A- 6 234 597
- JP-A- 6 340 491
- JP-A- 6 340 491
- JP-A- 8 073 293
- JP-A- 9 221 381
- JP-A- 11 116 392
- JP-A- 2003 327 493
- JP-A- 2004 224 642

## Description

### Technical Field

The present invention relates to a silicon single crystal and a silicon wafer which are produced by Czochralski Method (hereinafter, referred to as CZ method) and have few crystal defects and have high quality and high yield, a producing apparatus therefor, and a producing method therefor.

### Background Art

As one conventional method for producing a silicon single crystal, there has been widely known CZ method which comprises steps of, melting a raw material in a crucible, contacting a seed crystal on the melt surface, and growing a silicon single crystal.

In a method for growing a silicon single crystal by CZ method, polycrystalline silicon to be a raw material is filled in a crucible which is provided in a furnace for single crystal growth of a producing apparatus and made of graphite outside and made of quartz inside, an inert gas such as Ar is filled in the furnace for single crystal growth, and then, the raw material is heated to a high temperature of 1400 °C or more with a heating heater provided around the outside of the crucible to be melted. And, the seed crystal is lowered from above and the tip end thereof is contacted on the heated melted silicon melt. After temperatures of the seed crystal and the silicon melt become stable, the seed crystal is pulled upwardly with being gently rotated, and therewith a shoulder and a straight body are formed in order, and thereby a silicon single crystal is formed below the seed crystal.

Along with improvement of integration of semiconductor integrated circuit devices in recent years, requirement for higher quality of a silicon single crystal produced by CZ method becomes tougher. Along with this, requirement for concentration of impurities being contained in polycrystalline silicon that is raw material, a quartz crucible, and components made of graphite constituting the inside of the furnace, becomes tougher, and higher purity has been attempted. And, for example, an apparatus for producing a silicon single crystal by use of high-purity components made of graphite has been disclosed (see, for example, Japanese Patent Application Laid-open (kokai) No. 6-16495, No. 8-337493, No. 10-7488, and No. 2002-68886).

EP-A-0 691 423 discloses a fused silica glass crucible, of which the concentration of copper does not exceed 0.5 ppb by weight. The concentration of copper in the components made of quartz which are HZ components constituting the inside of the of the furnace, e.g. are other than a quartz crucible. Also, the concentration of copper in the components made of quartz in a specific temperature range is not disclosed.

EP-A-1 182 281 discloses pulling a single crystal having a length of constant diameter portion of about 100 cm at an average pulling weight of 2.0 mm/min. None of these documents discloses a process wherein after melting of a silicon raw material is finished, it is left for 3 hours or more on a condition that a heating heater is heated with an electric power of 80% or more of the power in the raw material melting and flow amount of an inert gas introduced in the furnace for single crystal growth is flow amount in the single crystal growth or more, and then, a silicon single crystal is grown.

JP 06 340491 A discloses disposing an apparatus for pulling in clean room, and cleaning components in a working room separated from the apparatus for pulling. The purpose of cleaning in the separated working room is to prevent flying dust from penetrating into other room during cleaning during cleaning hot zone parts and the like. Cleaning in a room environment in which cleanliness is class 1000 or more is not described.

Here, one of impurities introduced in the single crystal in production of a silicon single crystal is copper (Cu). Cu existing in a silicon single crystal and a silicon wafer produced therefrom forms Cu precipitates such as Cu silicides. It is known that if such a silicon wafer is put in a semiconductor device production process, Cu existing in the bulk of the wafer causes p-n junction leakage and has a bad effect on device characteristics (see, for example, Journal of The Electrochemical Society, 149 (1) G21-G30 (2002)).

On the other hand, particularly in a silicon single crystal whose entire region or part is a defect region having extremely few defects called as N-region, it has recently been a problem that crystal defects are observed in a surface of the silicon wafer produced therefrom at a frequency at high density.

### Disclosure of the Invention

Accordingly, the present invention was conceived in view of the above problems. An object of the present invention is to provide an apparatus according to claim 1 and a method according to claim 4. An object of the present invention is to provide a silicon single crystal and a silicon wafer which have extremely few crystal defects and have high quality and high yield, a producing apparatus therefor, and a producing method therefor.

In order to accomplish the above object, according to the present disclosure, there is provided a silicon single crystal grown by Czochralski method, wherein Cu precipitates do not exist inside the silicon single crystal.

In a silicon single crystal in which Cu precipitates do not exist inside as described above, OSF (Oxidation induced Stacking Fault) resulting from the Cu precipitates that have conventionally occurred at a frequency in the silicon single crystal by thermal oxidation treatment become not to occur. And, production yield thereof is improved, and it can be a silicon single crystal having high production efficiency and low cost and high quality.

In this case, it is preferable that a defect region in the silicon single crystal contains Nv region outside an OSF ring over the entire region in the direction of the crystal growth axis.

If a defect region in the silicon single crystal contains Nv region outside an OSF ring over the entire region in the direction of the crystal growth axis, the silicon single crystal can be one which high-density OSF resulting from Cu precipitates that have conventionally occurred selectively in Nv region having extremely few crystal defects does not occur in the Nv region. And the silicon single crystal can be one of which oxygen precipitation amount is large in the Nv region part in the thermal oxidation treatment, and of which gettering efficiency is high.

Moreover, it is preferable that a defect region in the silicon single crystal is Nv region outside an OSF ring over the entire region in the direction of the crystal growth axis.

If a defect region in the silicon single crystal is Nv region outside an OSF ring over the entire region in the direction of the crystal growth axis as described above, the silicon single crystal can be one which is N region having extremely few crystal defects. Additionally, the silicon single crystal can be one which high-density OSF resulting from Cu precipitates that have conventionally occurred selectively in Nv region does not occur in the entire region in the direction of the crystal growth axis. And the silicon single crystal can be one of which oxygen precipitation amount is large over the entire region in the thermal oxidation treatment, and of which gettering efficiency is high.

Moreover, it is preferable that Cu concentration in the silicon single crystal is less than 1 x 10¹² atoms/cm³.

If Cu concentration in the silicon single crystal is less than 1 x 10¹² atoms/cm³ as described above, the crystal can be a silicon single crystal in which Cu precipitates do not exist certainly inside and therefore OSF resulting from the Cu precipitates does not occur. Therefore, production yield thereof is improved, and it can be a silicon single crystal having high production efficiency and low cost and high quality.

Moreover, it is preferable that a diameter of the silicon single crystal is 200 mm or more.

When a diameter of the silicon single crystal is 200 mm or more as described above, Cu contamination which has been conventionally caused by components in the furnace due to increase of heat capacity along with enlargement of an apparatus for producing a silicon single crystal can be prevented. Therefore, production yield thereof is improved, and it can be a large-diameter silicon single crystal having high production efficiency and low cost and high quality.

Moreover, the present disclosure provides a silicon wafer produced from the above-described silicon single crystal, wherein Cu precipitates do not exist on a surface of and inside the wafer.

If a silicon wafer produced from any one of the above-described silicon single crystals is one in which Cu precipitates do not exist on a surface of the wafer and in the bulk inside the wafer as described above, it can be a wafer in which OSF resulting from Cu precipitates does not occur if thermal oxidation treatment is subjected to the silicon wafer. Therefore, production yield of the wafer is improved, and it can be a wafer having high production efficiency and low cost and high quality. Moreover, it can be one in which dielectric breakdown voltage characteristic of oxide film to be formed on the surface thereof is high and furthermore generation of p-n junction leakage resulting from Cu precipitates in a device production process is prevented, and production yield of devices can be also high.

Moreover, the present disclosure provides a silicon wafer produced from the above-described silicon single crystal, wherein deformed void defect does not exist on a surface of the wafer.

If a silicon wafer produced from any one of the above-described silicon single crystal is one in which deformed void defect does not exist on a surface of the wafer, deformed void defect which is determined as high-density particle when the wafer surface is observed by a particle counter and so forth and which causes lowering of production yield of the wafer does not exist. Therefore, production yield is improved and it can be a silicon wafer having high production efficiency and low cost and high quality. Moreover, oxide dielectric breakdown voltage characteristic can be also high and production yield of devices can be also high.

In addition, the term "deformed void defect" as mentioned here is void defect having a rod shape or a particular shape that extends along a [100] direction and along a [110] direction of a silicon single crystal.

In this case, it is preferable that one part of a defect region in the silicon wafer is Nv region outside an OSF ring.

If one part of a defect region in the silicon wafer is Nv region outside an OSF ring as described above, the silicon wafer can be one which high-density OSF resulting from Cu precipitates that have conventionally occurred selectively in Nv region having extremely few crystal defects does not occur in the Nv region. And the silicon wafer can be one of which oxide dielectric breakdown voltage characteristic is high. And the silicon wafer can be one which generation of p-n junction leakage can be prevented. And also, the silicon wafer can be one of which oxygen precipitation amount is large in the Nv region part in the thermal oxidation treatment, and of which gettering capability is high.

Moreover, it is preferable that a defect region in the silicon wafer is Nv region outside an OSF ring in the entire plane of the wafer.

If a defect region in the silicon wafer is Nv region outside an OSF ring in the entire plane of the wafer as described above, the silicon wafer can be one which is N region having extremely few crystal defects. And additionally, the silicon wafer can be one which high-density OSF resulting from Cu precipitates that have conventionally occurred selectively in Nv region does not occur in the entire region. And the silicon wafer can be one of which oxide dielectric breakdown voltage characteristic is high. And the silicon wafer can be one of which generation of p-n junction leakage can be prevented. And also, the silicon wafer can be one of which oxygen precipitation amount is large over the entire plane in performing the thermal oxidation treatment, and of which gettering capability is high.

Moreover, it is preferable that Cu concentration in the silicon wafer is less than 1 x 10¹² atoms/cm³.

If Cu concentration in the silicon wafer is less than 1 x 10¹² atoms/cm³, the wafer can be a silicon wafer in which neither Cu precipitates nor deformed void defect certainly exist, OSF resulting from Cu precipitates does not occur and also particles are not observed. And therefore, production yield of the silicon wafer is improved, and it can be a silicon wafer having high production efficiency and low cost and high quality. Moreover, it can be a wafer in which oxide dielectric breakdown voltage characteristic is high and generation of p-n junction leakage is prevented, and production yield of devices can be also high.

Moreover, the present invention provides an apparatus for producing a silicon single crystal according to Czochralski method, wherein Cu concentration in a component made of quartz to be used in a part in which a temperature in a furnace for single crystal growth is 1000 °C or more is 1 ppb or less, and Cu concentration in a component made of quartz to be used in a part in which a temperature in a furnace for single crystal growth is less than 1000 °C is 10 ppb or less; and wherein the components made of quartz are HZ components constituting the inside of the furnace.

If an apparatus for producing a silicon single crystal is one in which Cu concentration in a component made of quartz to be used in a part in which a temperature in a furnace for single crystal growth is 1000 °C or more is 1 ppb or less and Cu concentration in a component made of quartz to be used in a part in which the temperature is less than 1000 °C is 10 ppb or less as described above, it can be a single crystal-producing apparatus where concentration of Cu impurities in components made of quartz to be used in the growth furnace is regulated to have amount of extent so as not to form Cu precipitates in the silicon single crystal to be grown in the growth furnace according to temperature in the furnace in a part in which they are used, and therefore, Cu contamination in the single crystal in its growth is reduced and formation of Cu precipitates can be prevented. Moreover, because components made of quartz having unnecessarily high purity are not used in a part in which temperature in a furnace is low, it can be a producing apparatus having no extra high costs.

In this case, it can be preferable that devices and components being exposed in the furnace for single crystal growth do not contain Cu as a raw material.

Things containing Cu as a raw material have been conventionally used as parts of devices and components which are exposed in the single crystal growth furnace, such as a wire reeler, an isolation valve, a crucible axis, a driving mechanism thereof, and an electrode for a heating heater. However, by limiting them to the devices and components which do not contain Cu as a raw material as described above, the apparatus can be a single crystal-producing apparatus by which Cu contamination in the single crystal in its growth can be reduced more certainly. Here, not to contain Cu as a raw material means that material in which Cu is used when the devices and components are produced is not used, and it is natural that an extremely minute Cu elements which are inevitably mixed may be contained.

Moreover, the present disclosure provides a method for producing a silicon single crystal, wherein a silicon single crystal is grown by using the above-described apparatus for producing a silicon single crystal.

If a silicon single crystal is grown by using any one of the above-described apparatuses for producing a silicon single crystal as described above, Cu contamination in the single crystal growth is reduced. Therefore, a silicon single crystal of high quality in which Cu precipitates do not exist inside and OSF resulting from the Cu precipitates does not occur if thermal oxidation treatment is performed can be produced with high production yield at low cost.

In this case, it is preferable that when the silicon single crystal is grown, the silicon single crystal is grown so that a defect region therein contains Nv region outside an OSF ring over the entire region in the direction of the crystal growth axis.

If the silicon single crystal is grown so that a defect region therein contains Nv region outside an OSF ring over the entire region in the direction of the crystal growth axis as described above, there can be produced a silicon single crystal which high-density OSF resulting from Cu precipitates that have conventionally occurred selectively in Nv region having extremely few crystal defects does not occur in a part of the Nv region. And there can be produced a silicon single crystal of which oxygen precipitation amount is large in Nv region in the thermal oxidation treatment and of which gettering efficiency is high.

Moreover, it is preferable that when the silicon single crystal is grown, the silicon single crystal is grown so that a defect region therein is Nv region outside an OSF ring over the entire region in the direction of the crystal growth axis.

If the silicon single crystal is grown so that a defect region therein is Nv region outside an OSF ring over the entire region in the direction of the crystal growth axis, there can be produced a silicon single crystal which is N region having extremely few crystal defects. And there can be produced a silicon single crystal which high-density OSF resulting from Cu precipitates that have conventionally occurred selectively in Nv region does not occur in the entire region in the direction of the crystal growth axis. And there can be produced a silicon single crystal of which oxygen precipitation amount is large in the entire region in the thermal oxidation treatment and of which gettering efficiency is high.

Moreover, it is preferable that when in-furnace components in the furnace for single crystal growth are cleaned, the cleaning is performed in a room environment in which cleanliness is class 1000 or more.

When in-furnace components which consist of high-purity graphite, namely, when hot zone (HZ) components are cleaned, if the cleaning is performed in a room environment in which cleanliness is class 1000 or more as described above, Cu particles in the room are extremely few due to its cleanliness of the room environment and HZ components are not contaminated with Cu from the environment in the cleaning. Thus, there can be produced a silicon single crystal in which Cu precipitates are not formed inside.

It is preferable that after the silicon single crystal is grown, in-furnace components in the furnace for single crystal growth are cleaned in a room environment in which cleanliness is class 1000 or more, and then, a next silicon single crystal is grown by using the cleaned in-furnace components.

After the silicon single crystal is grown, if HZ components in the furnace for single crystal growth are cleaned in a room environment in which cleanliness is class 1000 or more in order to remove impurities such as silicon oxides to adhere to HZ components in the growth and to be the cause of degradation of the HZ components made of graphite and then a next silicon single crystal is grown by using the cleaned HZ components, degradation of the HZ components can be prevented, and also Cu particles are extremely few due to its cleanliness of the room environment, and HZ components are not contaminated with Cu in the cleaning. Thus, there can be provided a silicon single crystal in which Cu precipitates are not formed inside in the next silicon single crystal growth. In this case, the upper limitation of cleanliness is not limited. However, it is desirable that cleanliness is class 100 or less because equipment cost becomes higher as cleanliness becomes higher.

Moreover, it is preferable that when the in-furnace components are cleaned, cleaning tools and jigs which do not contain Cu as a raw material are used.

In particular, silicon single crystal growth according to MCZ method has been recently performed actively. As jigs to be used in the magnetic field environment, non-magnetic things containing Cu as a raw material have been generally used. Therefore, if cleaning tools and jigs which do not contain Cu as a raw material are used when HZ components are cleaned, a silicon single crystal can be produced with more certainly preventing Cu contamination because Cu contamination is not caused even if the cleaning tools and jigs are in contact with the HZ components.

Moreover, it is preferable that the furnace for single crystal growth is provided in a room environment in which cleanliness is class 1000 or more.

If the furnace for single crystal growth is provided in a room environment in which cleanliness is class 1000 or more as described above, Cu particles are extremely few in the room due to its cleanliness of the room environment, the growth furnace inside is not contaminated with Cu even when growth furnace inside is exposed to atmosphere in the room in such a time when the grown single crystal and HZ components to be cleaned are taken out of the growth furnace. Therefore, Cu contamination can be prevented more certainly, and thereby a silicon single crystal can be produced. At this time, the upper limitation of cleanliness is not particularly limited. However, it is desirable that cleanliness is class 100 or less because equipment cost becomes higher as the cleanliness becomes higher.

Moreover, it is preferable that after melting of a silicon raw material is finished, it is left for 3 hours or more on a condition that a heating heater is heated with an electric power of 80 % or more of the power in the raw material melting and flow amount of an inert gas introduced in the furnace for single crystal growth is flow amount in the single crystal growth or more.

After melting of a silicon raw material is finished, if it is left for 3 hours or more on a condition that a heating heater is heated with an electric power of 80 % or more of the power in the raw material melting and flow amount of an inert gas introduced in the furnace for single crystal growth is flow amount in the single crystal growth or more as described above, HZ components can be cleaned to the extent that Cu precipitates are not formed in the single crystal even when HZ components are subjected to Cu contamination in such a time as cleaning or takeout of HZ, and also, Cu removed from HZ components is certainly exhausted out of the furnace. Therefore, Cu contamination can be prevented more certainly, and thereby a silicon single crystal can be produced.

In this case, the upper limitations with respect to the electric power value of the heating heater, the flow amount of the inert gas such as argon, and the time period of the leaving, are not particularly limited. However, degradation of the quartz crucible is accelerated if it is heated with an electric power higher than the power in the raw material melting. Therefore, it is desirable that the heating heater is heated with an electric power in the raw material melting or less. Because cost is high if the flow amount of the gas is too large and the time period of the leaving is too long, it is desirable that they are flow amount of five times in the single crystal growth or less, and a time period of 24 hours or less, respectively.

Moreover, the present invention provides a method for producing a silicon single crystal by Czochralski method, wherein after melting of a silicon raw material is finished, it is left for 3 hours or more on a condition that a heating heater is heated with an electric power of 80 % or more of the power in the raw material melting and flow amount of an inert gas introduced in the furnace for single crystal growth is flow amount in the single crystal growth or more, and then, a silicon single crystal is grown.

After melting of a silicon raw material is finished, if it is left for 3 hours or more on a condition that a heating heater is heated with an electric power of 80 % or more of the power in the raw material melting and flow amount of an inert gas introduced in the furnace for single crystal growth is flow amount in the single crystal growth or more as described above, HZ components can be cleaned to the extent that Cu precipitates are not formed in the single crystal even when HZ components are subjected to Cu contamination in such a time as cleaning or takeout of HZ. And also, Cu removed from the HZ components can be certainly exhausted out of the furnace. Therefore, if a silicon single crystal is grown thereafter, Cu contamination in the single crystal growth is reduced. Therefore, a high-quality silicon single crystal in which Cu precipitates do not exist inside and in which OSF resulting from Cu precipitates does not occur even if thermal oxidation treatment is performed can be produced with high production yield at low cost.

In this case, the upper limitations with respect to the electric power value of the heating heater, the flow amount of the inert gas such as argon, and the time period of the leaving, are not particularly limited. However, also in this case, degradation of the quartz crucible is accelerated if it is heated with an electric power higher than the power in the raw material melting. Therefore, it is desirable that the heating heater is heated with an electric power in the raw material melting or less. Moreover, the flow amount of the gas and the time period of the leaving are the same as described above.

Moreover, the present invention provides a method for producing a silicon single crystal by Czochralski method, wherein when in-furnace components in the furnace for single crystal growth are cleaned, the cleaning is performed in a room environment in which cleanliness is class 1000 or more, and a silicon single crystal is grown by using the cleaned in-furnace components.

When HZ components in the furnace for single crystal growth are cleaned, if the cleaning is performed in a room environment in which cleanliness is class 1000 or more, and if a silicon single crystal is grown by using the cleaned HZ components, Cu particles in the room are extremely few because room environment is clean, and HZ components are not contaminated with Cu from the environment in the cleaning. Therefore, Cu contamination in the silicon single crystal growth is reduced. Therefore, a high-quality silicon single crystal in which Cu precipitates do not exist inside and in which OSF resulting from Cu precipitates does not occur even if thermal oxidation treatment is performed can be produced with high production yield at low cost. In this case, the upper limitation of cleanliness is not particularly limited. However, it is desirable that cleanliness is class 100 or less because equipment cost becomes higher as the cleanliness becomes higher.

Moreover, the present invention provides an apparatus for producing a silicon single crystal according to Czochralski method, wherein devices and components being exposed in the furnace for single crystal growth do not contain Cu as a raw material.

Things containing Cu as a raw material have been conventionally used as parts of devices and components which are exposed in the single crystal growth furnace, such as a wire reeler, an isolation valve, an axis of crucible, a driving mechanism thereof, and an electrode for a heating heater. However, by limiting them to the devices and components which do not contain Cu as a raw material as described above, the apparatus can be a single crystal-producing apparatus by which Cu contamination in the single crystal in its growth can be reduced and formation of Cu precipitates can be prevented.

Moreover, the present invention provides an apparatus for producing a silicon single crystal according to Czochralski method, wherein Cu concentration in an observation window made of quartz provided in the furnace for single crystal growth is 10 ppb or less.

If Cu concentration in an observation window made of quartz which is provided in the furnace for single crystal growth and which is for observing a single crystal in its growth is 10 ppb or less as described above, the apparatus can be a single crystal-producing apparatus in which Cu contamination of a single crystal in its growth can be reduced due to an observation window made of quartz and formation of Cu precipitates can be prevented.

Moreover, the present disclosure provides a method for producing a silicon single crystal by using a combined apparatus of at least two or more of the producing apparatus in which Cu concentration in a component made of quartz is determined, the producing apparatus in which Cu in devices and the like to be exposed in the furnace is determined, and the producing apparatus in which Cu concentration of an observation window made of quartz is determined. Furthermore, the present disclosure provides a method for producing a silicon single crystal, wherein a silicon single crystal is grown by a combined method of the method for performing heating with a heating heater after melting of raw material and the method for cleaning HZ components in a clean environment.

If a silicon single crystal is grown by combining at least two or more from among the producing apparatuses or the producing methods by considering Cu contamination level or cost and effect for preventing Cu contamination, Cu contamination in the growth can be reduced more effectively and more certainly. And, formation of Cu precipitates can be prevented.

Moreover, the present disclosure provides a silicon wafer produced from a silicon single crystal grown by Czochralski method, wherein density of deformed void defects on a surface of the wafer is 0.01 number/cm² or less.

If a silicon wafer produced from a silicon single crystal grown by Czochralski method is one in which density of deformed void defects on a surface of the wafer is 0.01 number/cm² or less, the wafer surface is not determined as a particle fault when the wafer surface is observed by a particle counter or the like, and OSF resulting from Cu precipitates having occasionally occurred selectively in Nv region does not occur, either. Therefore, production yield thereof is improved, and it can be a silicon wafer having high production efficiency and low cost and high quality. Moreover, oxide dielectric breakdown voltage characteristic can be high and production yield of devices can be also high.

With respect to the silicon single crystal according to the present disclosure, Cu concentration in the silicon single crystal can be less than 1 x 10¹² atoms/cm³. Therefore, the crystal can be a silicon single crystal in which OSF resulting from the Cu precipitates that have conventionally occurred at a frequency in the silicon single crystal by thermal oxidation treatment does not occur. And, production yield thereof can be improved and the crystal can be a silicon single crystal having high production efficiency, low cost, and high quality.

Moreover, with respect to the silicon wafer according to the present disclosure, it can be one in which OSF resulting from Cu precipitates does not occur if thermal oxidation treatment is subjected to the silicon wafer. Therefore, production yield of the wafer is improved, and it can be a wafer having high production efficiency and low cost and high quality. Moreover, it can be one in which dielectric breakdown voltage characteristic of oxide film to be formed on the surface thereof is high and furthermore generation of p-n junction leakage resulting from the Cu precipitates in a device production process is prevented. Thus, harmful effect of Cu precipitates or deformed void defect exerted in device production process can be reduced drastically and therefore production yield of devices can be also high.

Moreover, the apparatus for producing a silicon single crystal according to the present invention can be a single crystal-producing apparatus by which Cu contamination in a single crystal in its growth can be reduced and formation of Cu precipitates can be prevented.

Furthermore, in accordance with the method for producing a silicon single crystal according to the present invention, the above-described silicon single crystal of high quality can be produced with high production yield at low cost.

### Brief Explanation of the Drawings

Fig. 1 is a view of observing a distribution of single crystal defects on a wafer surface by use of a laser microscope.
Fig. 2 is an observation view showing deformed void defect on a surface of a wafer observed by use of TEM.
Fig. 3 is an observation view showing a needle-like defect (Cu precipitates) in the bulk of a wafer which is observed by use of TEM.
Fig. 4 is a schematic section view showing an example of an embodiment of an apparatus for producing a silicon single crystal according to CZ method of the present invention.

### Best Mode for Carrying out the Invention

Hereinafter, the present invention will be explained in detail.

As described above, particularly with respect to a silicon single crystal whose entire region or part is a defect region having extremely few defects called as N-region, it has recently been a problem that crystal defects are observed on a surface of a silicon wafer produced therefrom at a frequency at high density. And, in the case that such crystal defects exist at high density, they are observed as high-density particles when the wafer surface is measured by a particle counter. The wafer in which high-density particles exist is determined as a particle fault and becomes a defective. As a result, degradation of production yield has been caused.

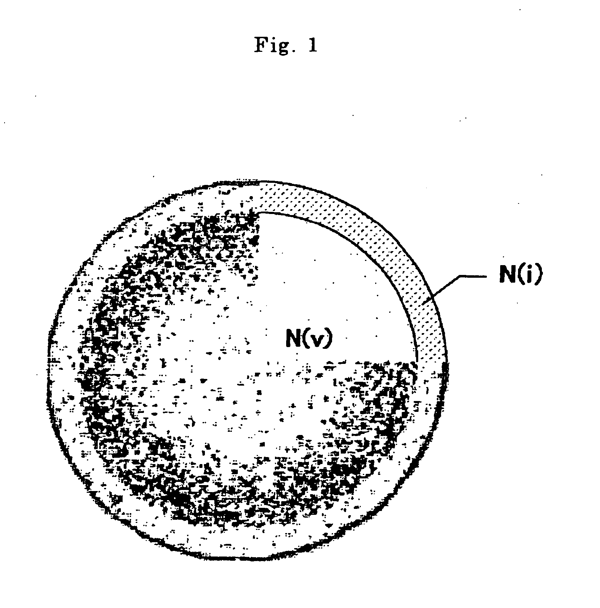

Such crystal defects have almost never been conventionally observed. The present inventors have investigated the crystal defects and therefore found that they have characteristics as follows.
(1) With respect to this crystal defect, probability of occurrence in a region near the shoulder of a single crystal was extremely high, and frequency of the occurrence was about 20%.
(2) In evaluation by a particle counter (For example, a surface measurement apparatus SP1 manufactured by KLA-Tencor Co., Ltd.) and a laser microscope (For example, MAGICS (name of an article) manufactured by Laser Tech Co., Ltd.), the above-described crystal defects are observed in a ring shape in Nv region (a region which is just outside an OSF ring and has a few atomic vacancies in N region) part of defect regions and have higher density in Nv region nearer to Ni region (a region having a few interstitial silicones in N region). Fig. 1 is a view of observing a distribution of the single crystal defects on a wafer surface by use of the above-described laser microscope, and the upper right part shows that the peripheral part of the wafer is Ni region and a part inside it is Nv region.
(3) By subjecting the above-described wafer to thermal oxidation treatment, OSF can be observed at high density in the defect occurrence part in Nv region. And, by performing chemical preferential etching (Secco etching), projection was observed in the defect occurrence part in Nv region.

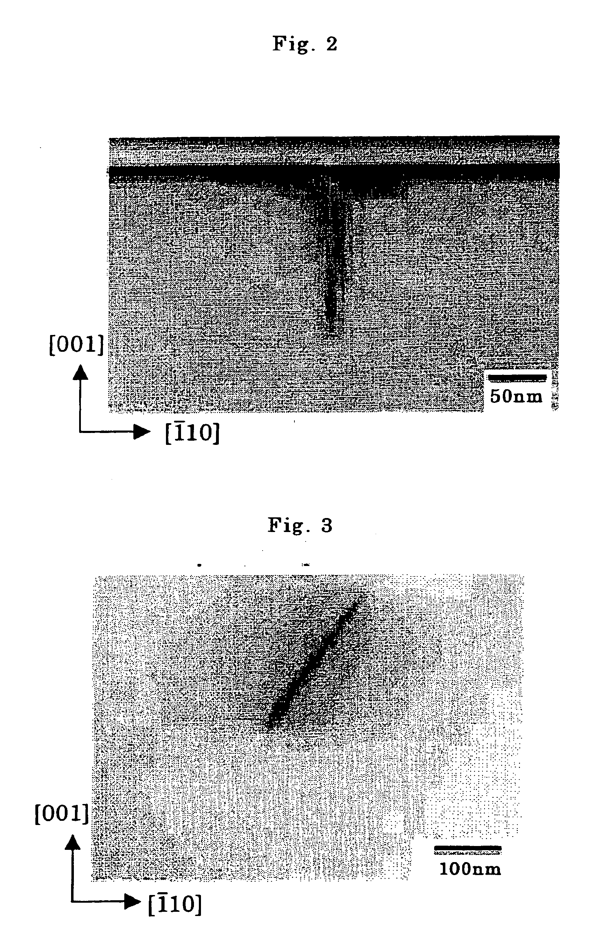

Next, the present inventors investigated the defects on a wafer surface and in a bulk by TEM (Transmission Electron Microscope) for ascertaining real identity of this crystal defect. As a result, the follows were confirmed.
(1) On a wafer surface, a rod-like or an odd-shaped "deformed void defect" extending along a [100] direction and a [110] direction of a silicon single crystal was discovered. Moreover, no impurities were detected from this "deformed void defect". Fig. 2 is a picture showing deformed void defect on a surface of a wafer observed by use of TEM.
(2) And, needle-like defects were observed in the bulk of the wafer. Fig. 3 is a picture showing a needle-like defect in the bulk observed by use of TEM.

And, the present inventors detect Cu from this needle-like defect. From this, it is presumed that this needle-like defect is a Cu precipitate.

From characteristics of occurrence of the above-described crystal defects and an observation results of the crystal defects, occurrence mechanisms of the above-described crystal defects can be considered such as follows.
(1) Cu is taken in a silicon single crystal by diffusion from a surface of the single crystal in its growth.
(2) And, Cu precipitates are formed selectively in Nv region in which precipitates are easy to be formed energetically.
(3) If the wafer sliced from the above-described single crystal is subjected to thermal oxidation treatment in a wafer-processing step, OSF resulting from Cu precipitates is formed at high density.
(4) Furthermore, by cleaning a wafer surface in particular, Cu precipitates on the surface are removed and periphery of the Cu precipitates is eroded. Thereby, deformed void defect is formed on a surface of a mirror wafer through the removal of Cu precipitates and the erosion of the periphery of the Cu precipitates. This is observed as a particle on a wafer surface at density of 0.1-5 numbers/cm² (for example, about 100 - several thousands numbers in a wafer having a diameter of 300 mm).

From these knowledges, the present inventors have thought that if taking of Cu in a single crystal in the single crystal growth can be prevented, occurrence of the new type crystal defect as described above can be prevented and it can be a high-quality silicon single crystal.

Accordingly, next, studies of the cause that Cu is introduced to the single crystal was performed.

In general, in a single crystal growth furnace of an apparatus for producing a silicon single crystal, a polycrystalline silicon to be a raw material, and a quartz crucible, exist. And, components made of graphite, heat shielding members made of graphite, and components made of quartz, which are HZ components constituting the inside of the furnace, exist. Therefore, as a contamination source of Cu, raw materials thereof and components in the furnace and the growth furnace in itself can be thought of. Furthermore, from occurrence of the above-described crystal defects only in the shoulder of the single crystal, and from the occurrence frequency of about 20 % and not 100 %, and further, from traditional accomplishment of higher purity of the quartz crucible and the graphite components whose purity directly effects on the crystal quality, the other HZ components are focused attention on. And, when the relation of exchange time of the HZ components and occurrence of the above-described crystal defects has been investigated, it has been confirmed that the timing of exchange of components made of quartz arranged in a part having a furnace temperature of the relatively low temperature of less than 1000 °C such as an observation window made of quartz provided at a position being 800 °C or less in the single crystal growth furnace for observing a single crystal in its growth, and timing of occurrence of the above-described crystal defects, correspond to each other at an extremely high probability. And, it has been found that Cu concentration in components made of quartz such as this observation window relates to occurrence of the above-described crystal defects. Furthermore, the present inventors found that the above-described crystal defects occur when Cu concentration in the silicon single crystal is 1 x 10¹² atoms/cm³ or more.

Components made of quartz have low heat resistance as compared to components made of graphite. Therefore, conventionally, it has frequently been used at such a relatively low temperature as 1000 °C or less and at a position being also away from the single crystal to be grown. It has been thought that in the case of being used at such a position, the purity also has little effect on the crystal quality of the single crystal. Therefore, it has not been performed that in the use of components made of quartz, components limited to things of high purity are used. However, from the above-described result, it has been found that with respect to components made of quartz being used in such a low temperature position, things of high purity are required to be used as well as cases of high temperature.

However, components made of quartz are expensive. With considering cost of exchange thereof, it has been found that if purity of components made of quartz is determined according to furnace temperature in a part of being used in the components made of quartz, Cu contamination can be prevented.

Next, the present inventors investigated whether Cu impurities are taken in a silicon single crystal due to another cause.

First, effects of such very extremely small amount of Cu impurities have not been conventionally studied sufficiently. Therefore, things containing Cu as a raw material have been conventionally used as parts of devices and components which are exposed in single crystal growth furnace, such as a wire reeler, an isolation valve, an axis of crucible, a driving mechanism thereof, and an electrode for a heating heater which are not in contact with the raw material melt and are limited in temperature rising by being cooled down or the like in an apparatus for producing a single crystal. Therefore, it is thought that if these devices or
components do not contain Cu as a raw material, Cu contamination of a silicon single crystal can be prevented.

Moreover, in production of a single crystal according to CZ method, the inside of a growth furnace is once vacuumized, and then, growth of the single crystal is initiated after the atmosphere in the furnace is replaced with an argon gas. Therefore, it has been thought that cleanliness in a room environment in which the single crystal-producing apparatus is provided does not have large effects on crystal quality of the single crystal. However, from a result of exposure test that a mirror wafer is left in the furnace for single crystal growth, it has been found that Cu is detected from the mirror wafer in an environment in which cleanliness in a room environment where a single crystal-producing apparatus is provided is degraded.

And, there are cases that after production of a single crystal is finished, the HZ components perform cleaning on a condition of a relatively high temperature in the room where the single crystal-growing apparatus is provided. It has been confirmed that if Cu level in the room is high in these cases, the HZ components are contaminated with Cu, and if a silicon single crystal is produced by use of the HZ components, the above-described crystal defects occurs. Furthermore, with respect to a single crystal produced according to a single crystal growing-apparatus that is provided in a room having high Cu level, the similar crystal defects have been observed.

It is general to think that Cu is contained in the particle. Therefore, from these results as described above, it has been proved that for preventing occurrence of such a new type of crystal defect as described above, it is necessary that cleaning of HZ components and growth of the single crystal are performed in a room having a low particle level and high cleanliness.

Furthermore, it is necessary that cleaning tools and jigs to be used in the cleaning of HZ components have also been paid attention to. It has been thought that if cleaning tools and jigs which do not contain Cu as a raw material are used, thereby the HZ components are not subjected to Cu contamination.

Moreover, the present inventors have studied a method for preventing Cu contamination of a silicon single crystal even in the case that HZ components or the like are contaminated with extremely small amount of Cu. As a result, it has
been thought that by heating the heating heater to heat the HZ components after melting of a silicon raw material is finished, the HZ components can be cleaned to the extent that Cu precipitates are not formed in the single crystal even if the HZ components are subjected to Cu contamination.

As described above, it is proved that with respect to factors which have conventionally thought to have small effect on crystal defects and have not particularly been paid attention to, they are also likely to cause Cu contamination which is an occurrence cause of new type crystal defects which have newly been found out at this time. Therefore, for preventing occurrence of the above-described crystal defects, it becomes important to more reduce the total amount of Cu taken in the crystal. Accordingly, the present inventors found that by taking measures for respective Cu contamination causes having been studied as described above, the occurrence of the above-described crystal defects can be prevented. Thereby, the present invention has been accomplished.

Hereinafter, embodiments according to the present invention will be explained by providing examples with reference to drawings.

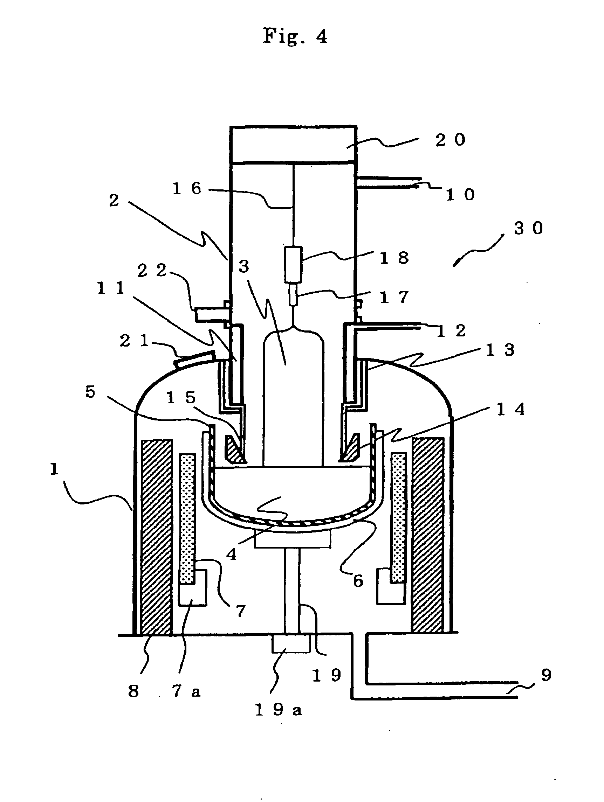

Fig. 4 is a schematic section view showing an example of an embodiment of an apparatus for producing a silicon single crystal according to CZ method of the present invention. Hereinafter, this apparatus for producing a silicon single crystal and a method for producing a silicon single crystal by use of this will be explained. A silicon single crystal-producing apparatus 30 shown in Fig. 4 is constituted by a growth furnace main body 1 and an upper growth furnace 2. Inside the growth furnace main body 1, for holding and protecting a crucible 5 made of quartz containing a silicon melt 4, a crucible 6 made of graphite is arranged outside of the crucible 5 made of quartz.

And, outside the crucible 6 made of graphite, a heating heater 7 made of graphite for heating to melt polycrystalline silicon to be a raw material being contained in the crucible 5 made of quartz into a silicon melt 4 is placed. In the growth of a silicon single crystal, an electric power is provided to the heating heater 7 from an electrode 7a connected to the heating heater 7, and the heating heater 7 generates heat and the polycrystalline silicon is melted, and then, the temperature of the silicon melt 4 is held to a desired value and thereby growth of a silicon single crystal 3 can be accomplished. As the electrode 7a being exposed in such a growth furnace, things containing Cu as a raw material have been conventionally used. However, in the present invention, by using a thing that does not contain Cu as the electrode 7a, e.g., carbon for a part to be exposed in the growth furnace, Cu contamination of the silicon single crystal to be grown can be prevented.

Between the heating heater 7 and the furnace wall of the growth furnace main body 1, an in-furnace heat shielding member 8 made of carbon is placed for protecting the furnace wall made of metal and protecting effectively the inside of the growth furnace main body 1. Furthermore, for the purpose of preventing the furnace wall from being heated to a high temperature by radiant heat from the heating heater 7 in the silicon single crystal growth, the furnace wall of the growth furnace main body 1 consists of a double structure so that a silicon single crystal may be grown with performing forced cooling with flowing cooling water into a gap of the furnace wall.

On the other hand, a crucible 6 made of graphite provided in about the center of the growth furnace main body 1 is supported at the bottom thereof by a supporting axis 19 made of graphite, and it is capable of vertical movement and rotational movement by a crucible axis-driving mechanism 19a attached in the lower end of the crucible-supporting axis 19. Thereby, it is possible to hold the melt surface of the silicon melt 4 at a fixed position in the single crystal growth, or to rotate the crucibles 5 and 6 in a desired direction or at a desired speed in the single crystal growth. With respect to components to be used in the crucible-supporting axis 19 and the crucible axis-driving mechanism 19a which are exposed in this growth furnace, things which are different from conventional ones and which do not contain Cu as a raw material are used. Thereby, Cu contamination of a silicon single crystal to be grown can be prevented.

Next, in the growth of a silicon single crystal 3, it is required to perform crystal growth with flowing an inert gas such as an argon gas through the growth furnace so that oxides such as SiO to vapor from the silicon melt 4 is prevented from adhering to the in-furnace wall of the growth furnace or in-furnace members such as an in-furnace graphite member. Therefore, at the bottom of the growth furnace main body 1, a gas outlet duct 9 for exhausting the inert gas out of the furnace and a pressure control device which is not shown in the Figure for controlling pressure inside the growth furnace are provided. In the growth of a silicon single crystal, pressure in the furnace is adjusted to a desired value by this pressure control device.

On the other hand, at the ceiling part of the growth furnace main body 1, an observation window 21 made of quartz glass for observing inside of the furnace. And, for containing and taking out the silicon single crystal 3 pulled from the silicon melt 4, an upper growth furnace 2 is provided continuously through an isolation bulb 22. For components of the isolation bulb 22 to be exposed in this growth furnace, things which are different from conventional ones and which do not contain Cu as a raw material are used. And, after finishing the single crystal growth, the silicon single crystal 3 is made to be standing to cool in this upper growth furnace 2. And, when the crystal temperature is lowered to the temperature at which the crystal can be taken out, a door which is not shown in the upper growth furnace 2 is opened and a silicon single crystal 3 is taken out of the growth furnace.

From the ceiling of the growth furnace main body 1, a crystal cooling cylinder 13 is arranged toward the silicon melt surface so that a single crystal 3 pulled from the silicon melt 4 is surrounded thereby. At the end of it, a quartz glass component 15 is provided so that a single crystal in its growth can be observed from the observation window 21 attached at the ceiling of the growth furnace main body 1.

In the present invention, in relation to the observation window 21 made of quartz glass attached at the ceiling of the growth furnace main body 1, the Cu concentration therein is made to be 10 ppb or less because an in-furnace temperature is less than 1000 °C in a part where it is used. And, in relation to a quartz glass component 15 to be provided at the end of the crystal cooling cylinder 13, the Cu concentration therein is made to be 1 ppb or less because an in-furnace temperature is 1000 °C or more in a part where it is used. Thereby, Cu contamination in the single crystal in its growth can be prevented and extra high cost can be prevented. Conventionally, as a quartz glass component 15 provided in the crystal cooling cylinder, things that contain Cu having 10 ppb or less have been used because it is possible to have effect on a crystal quality. However, the observation window 21 has been thought not to have effect, so one of low purity has been used. With respect to this, ones of high-purity are used respectively in the present invention.

Moreover, in the outer circumferential surface of the end of the crystal cooling cylinder 13, a heat shielding ring 14 made of graphite for keeping the heat in the silicon melt surface by reflecting effectively the radiant heat of the silicon melt 4 or the heating heater 7 is attached (the heat shielding ring 14 may be omitted). In the growth of the silicon single crystal 3, the crystal growth rate can be enhanced by depriving effectively the radiant heat from the silicon single crystal 3 with this crystal cooling cylinder 13. Moreover, this crystal cooling cylinder 13 has a flow-straightening function for the inert gas to flow down to the silicon melt surface through the inside of the cooling cylinder from the upper growth furnace 2, and also functions for exhausting such oxides as to be released from the melt surface out of the furnace without delay.

In the present invention, after melting of a silicon raw material is finished, it is left for 3 hours or more on a condition that the heating heater 7 is heated with an electric power of at least 80 % or more of the power in the raw material melting and flow amount of an inert gas such as an argon gas is flow amount to be used in the crystal growth or more. Thereby, graphite members subjected to Cu contamination and so forth are cleaned, and Cu occurring therefrom is certainly exhausted out of the furnace. Thus, Cu contamination in the single crystal in its growth can be prevented.

Furthermore, on the upper part of the crystal cooling cylinder 13, there is provided a forced cooling cylinder 11 for exhausting forcibly the radiant heat from the crystal out of the furnace by flowing a coolant medium from a flow-through entrance 12. Thereby, cooling effect is further enhanced (the forced cooling cylinder 11 may be omitted).

Because the cooling effect of the crystal can be enhanced as described above, by setting the crystal growth conditions such as temperature gradient in the crystal and pulling rate thereof appropriately, it becomes possible to produce a silicon single crystal which contains Nv region outside an OSF ring over the entire region in the direction of the crystal growth axis, as well as to produce a silicon single crystal which is Nv region outside an OSF ring over the entire region in the direction of the crystal growth axis.

And, in the upper growth furnace 2, a gas inlet duct 10 for introducing an inert gas inside the growth furnace is provided, and an inert gas is introduced into the growth furnace through the gas inlet duct in time with processes of the crystal growth operations. In the growth of the silicon single crystal 3, an inert gas introduced from the gas inlet duct 10 in this upper growth furnace 2 flows down inside the crystal cooling cylinder 13 and comes over the silicon melt surface and is exhausted from a gas outlet duct 9 to the out-furnace at the bottom of the growth furnace main body 1. Thereby, evaporant such as SiO vaporizing from the silicon melt is removed to the out-furnace.

Moreover, in the upside of the upper growth furnace 2, there is provided a wire reeling mechanism 20 for winding off or reeling off a pulling wire 16 in order to pull the silicon single crystal 3 from the silicon melt 4. For components of this wire reeling mechanism 20, things containing Cu as a raw material have been conventionally used. However, it is desirable to change them to things that do not contain Cu. And, a seed crystal 17 is fixed to a seed crystal holder 18 at the end of the pulling wire 16 wound off from this wire reeling mechanism 20, and the tip end of the seed crystal is brought into contact with the surface of the silicon melt 4 and it is pulled with rotation. Then, a shoulder and
a straight body are formed in order, and thereby a silicon single crystal 3 is grown below the seed crystal 17.

Moreover, as described above, by setting the crystal growth condition such as a pulling rate to be appropriate, there can be produced a silicon single crystal which contains Nv region outside an OSF ring over the entire region in the direction of the crystal growth axis, or a silicon single crystal which is Nv region outside an OSF ring over the entire region in the direction of the crystal growth axis.

After the single crystal growth is finished as described above, the heating heater 7 is shut off and made to be standing to cool to the temperature in which the silicon single crystal and the HZ components in the growth furnace can be taken out. And, when the temperature of the silicon single crystal and the HZ components is lowered, the silicon single crystal is taken out of a door that is not shown in the upper growth furnace 2 as described above. Then, the growth furnace main body 1 and the upper growth furnace 2 are separated off, and HZ components to which oxides or the like adhere are taken out of the furnace, and cleaning operation for removing the oxides or the like is performed.

In the present invention, by maintaining the cleanliness in the room environment in which the silicon single crystal-producing apparatus 30 is provided to be high cleanliness of class 1000 or more, Cu contamination in the inside of the growth furnace and the HZ components can be prevented from atmosphere to flow in the growth furnace in separating the growth furnace main body 1 and the upper growth furnace 2 as described above. Moreover, by maintaining the cleanliness in the room environment to be high cleanliness of class 1000 or more in the cleaning of the HZ components, Cu contamination in the HZ components can be prevented.

In this case, the cleaning of the HZ components may be performed in the room in which the silicon single crystal-producing apparatus 30 is provided. However, it is possible that after the HZ components are taken out of the furnace, the HZ components is transferred to another room in which cleanliness in the room environment is class 1000 or more and the cleaning is performed. By this way, degradation of the environment of the room, in which the single crystal-producing apparatus is provided, by scattering of particles or the like along with the cleaning operation can be prevented.

Moreover, in this case, if the HZ components are attached or removed or cleaned by using cleaning tools and jigs which do not contain Cu as a raw material, Cu contamination can be prevented due to the cleaning tools and jigs. For example, jigs for taking HZ components having high weight out of the furnace or for attaching them in the furnace and components of the cleaner for removing oxides by suction are made to be things which do not contain Cu. In particular, members to be used in a place being directly in contact with HZ components are made to be things which do not contain Cu.

The HZ components cleaned in the room environment having high cleanliness are not contaminated with Cu as described above. Therefore, by growing a next silicon single crystal by use of this, Cu contamination due to the HZ components in the silicon single crystal growth can be prevented.

The above-mentioned methods, namely, such as methods in which (1) as devices or components to be exposed in the growth furnace, devices or the like that do not contain Cu as a raw material is used, or (2) cleanliness of room environment for providing the producing apparatus or cleaning the HZ components is enhanced, or (3) after melting of the silicon raw material, it is heated with the heating heater and left and HZ components or the like are cleaned, are effective methods for preventing Cu contamination of the silicon single crystal even if any one of them is performed independently. However, by combining and performing these methods, Cu contamination can be prevented more certainly.

A silicon single crystal produced by this way can be one in which Cu precipitates do not exist inside and particularly Cu concentration can be less than 1 x 10¹² atoms/cm³ and therefore no Cu precipitates exist more certainly. In particular, by setting the crystal growth condition to be appropriate, the crystal can be a silicon single crystal which contains Nv region outside an OSF ring over the entire region in the direction of the crystal growth axis, or a silicon single crystal which is Nv region outside an OSF ring over the entire region in the direction of the crystal growth axis.

And, the silicon wafer produced by being sliced from this silicon single crystal can be not to have Cu precipitates inside or on the surface thereof and particularly Cu concentration can be less than 1 x 10¹² atoms/cm³ and therefore it can be a wafer in which Cu precipitates do not exist
more certainly. Furthermore, because Cu precipitates do not exist, the wafer can be one in which when the wafer surface is cleaned, density of deformed void defects on the wafer surface is extremely small, 0.01 numbers/cm² or less (For example, about 10 numbers or less in a wafer having a diameter of 300 mm) and particularly void defects do not occur. Moreover, the wafer can be a silicon wafer in which one part of the wafer is Nv region or the entire plane of the wafer is Nv region.

Hereinafter, Examples and Comparative Examples of the present invention are exemplified and the present invention is more explained specifically.

### (Example 1)

Quartz glass of high purity having Cu concentration of about 8 ppb was used as an observation window attached at the upside of the growth furnace main body. And, 300 kg of silicon polycrystal was charged in a quartz crucible having a diameter of 32-inch (800 mm). And, 10 silicon single crystals having a straight body length of 100 cm were pulled. And further, wafers were sliced from the straight body by intervals of 10 cm as measured from the shoulder of the silicon single crystal. And, they were processed to mirror wafers and crystal defects on the wafer surface were observed. In this case, the pulling of the single crystal was performed with controlling the production condition so that the crystal becomes N region containing Nv region outside an OSF ring over the entire region in the direction of the crystal growth axis. As a result, no deformed void defect was observed on surfaces of the every wafers. In this case, Cu concentration in the silicon single crystal was 5 x 10¹⁰ atoms/cm³ or less.

### (Comparative Example 1)

The same evaluation as Example 1 was performed but quartz glass of purity having Cu impurities of about 100 ppb was used as an observation window attached at the upside of the growth furnace main body. As a result, deformed void defect was observed in the Nv region of the wafers sliced from the region of 40cm of the straight bodies as measured from the shoulder in two single crystals. In this case, the density of deformed void defects was 1.5 numbers/cm². And, Cu concentration in the silicon single crystal in which deformed void defect was not observed was 8 x 1011 atoms/cm³ or less, and Cu concentration in the silicon single crystal in which deformed void defect was observed was 5 x 10¹² atoms/cm³ or more.

### (Example 2)

HZ components were cleaned under the room environment of class 100 and the HZ components were used. 300 kg of silicon polycrystal was charged in a quartz crucible having a diameter of 32-inch (800 mm). And, a silicon single crystal having a straight body length of 100 cm was pulled. And further, wafers were sliced from the straight body by intervals of 10 cm as measured from the shoulder of the silicon single crystal. And, they were processed to mirror wafers and crystal defects on the wafer surface were observed. In this case, the pulling of the single crystal was performed with controlling the production condition so that the crystal becomes N region containing Nv region outside an OSF ring over the entire region in the direction of the crystal growth axis. As a result, no deformed void defect was observed on surfaces of the every wafers. In this case, Cu concentration in the silicon single crystal was 1 x 10¹⁰ atoms/cm³.

### (Comparative Example 2)

The same evaluation as Example 2 was performed but HZ components were cleaned in an environment that was not in a clean room and the HZ components were used. As a result, deformed void defect was observed in the Nv region of the wafer sliced from the region of 30 cm of the straight body as measured from the shoulder. In this case, the density of deformed void defects was 0.3 numbers/cm². And, Cu concentration in the silicon single crystal in which deformed void defect was observed was 2 x 10¹² atoms/cm³.

### (Example 3)

HZ components were cleaned in an environment that was not in a clean room and the HZ components were used. 300 kg of silicon polycrystal was charged in a quartz crucible having a diameter of 32-inch (800 mm). After melting of the raw material was finished, the electric power of the heating heater was left for three hours with the same electric power as the power in the melting. In this case, flow amount of an argon gas was 200 l/min to be used in the crystal growth, the pressure in the furnace was 200 mbar. And, a silicon single crystal having a straight body length of 100 cm was pulled. And further, wafers were sliced from the straight body by intervals of 10 cm as measured from the shoulder of the silicon single crystal. And, they were processed to mirror wafers and crystal defects on the wafer surface were observed. In this case, the pulling of the single crystal was performed with controlling the production condition so that the crystal becomes N region containing Nv region outside an OSF ring over the entire region in the direction of the crystal growth axis. As a result, no deformed void defect was observed on surfaces of the every wafers. In this case, Cu concentration in the silicon single crystal was 1 x 10¹⁰ atoms/cm³

## Claims

1. An apparatus for producing a silicon single crystal according to Czochralski method, wherein Cu concentration in a component made of quartz to be used in a part in which a temperature in a furnace for single crystal growth is 1000 °C or more is 1 ppb or less, and Cu concentration in a component made of quartz to be used in a part in which a temperature in a furnace for single crystal growth is less than 1000 °C is 10 ppb or less; and wherein the components made of quartz are HZ components constituting the inside of the furnace.

2. The apparatus for producing a silicon single crystal according to Claim 1, wherein devices and components being exposed in the furnace for single crystal growth do not contain Cu as a raw material.

3. The apparatus for producing a silicon single crystal according to Claim 1 or Claim 2, wherein Cu concentration in an observation window made of quartz provided in the furnace for single crystal growth is 10 ppb or less.

4. A method for producing a silicon single crystal by Czochralski method, comprising at least one of a process wherein after melting of a silicon raw material is finished, it is left for 3 hours or more on a condition that a heating heater is heated with an electric power of 80 % or more of the power in the raw material melting and flow amount of an inert gas introduced in the furnace for single crystal growth is flow amount in the single crystal growth or more, and then, a silicon single crystal is grown; and a process, wherein when in-furnace components in the furnace for single crystal growth are cleaned, the cleaning is performed in a room environment in which cleanliness is class 1000 or more, and a silicon single crystal is grown by using the in-furnace cleaned components.

5. The method for producing a silicon single crystal according Claim 4, wherein when the in-furnace components are cleaned, cleaning tools and jigs which do not contain Cu as a raw material are used.

## Patentansprüche

1. Vorrichtung zur Herstellung eines Silizium-Einkristalls nach dem Czochralski-Verfahren, wobei die Cu-Konzentration in einer Komponente, hergestellt aus Quarz, zur Verwendung in einem Teil, in welchem eine Temperatur in einem Ofen für das Einkristall-Wachstum 1000°C oder mehr ist, 1 ppb oder weniger beträgt, und die Cu-Konzentration in einer Komponente, hergestellt aus Quarz, zur Verwendung in einem Teil, in welchem eine Temperatur in einem Ofen für das Einkristall-Wachstum weniger als 1000°C ist, 10 ppb oder weniger beträgt; und wobei die Komponenten, hergestellt aus Quarz, HZ-Komponenten sind, die das Innere des Ofen bilden.

2. Die Vorrichtung zur Herstellung eines Silizium-Einkristalls nach Anspruch 1, wobei Geräte und Komponenten, die in dem Ofen für das Einkristall-Wachstum exponiert sind, kein Cu als Rohstoff enthalten.

3. Die Vorrichtung zur Herstellung eines Silizium-Einkristalls nach Anspruch 1 oder Anspruch 2, wobei die Cu-Konzentration in einem Beobachtungsfenster, hergestellt aus Quarz, das in dem Ofen für das Einkristall-Wachstum zur Verfügung gestellt ist, 10 ppb oder weniger beträgt.

4. Verfahren zur Herstellung eines Silizium-Einkristalls nach dem Czochralski-Verfahren, umfassend zumindest eines von einem Verfahren, wobei, nachdem das Schmelzen eines Silizium-Rohstoffs beendet ist, es für 3 Stunden oder mehr bei einer Bedingung gelassen wird, dass ein Wärmeheizer mit einer elektrischen Energie von 80% oder mehr der Energie des Rohstoffsschmelzens gewärmt wird und die Flussmenge eines inerten Gases, eingeführt in den Ofen für das Einkristall-Wachstum, eine Flussmenge des Einkristall-Wachstums oder mehr ist, und dann ein Silizium-Einkristall gewachsen wird; und einem Verfahren, wobei, wenn Inner-Ofen Komponenten in dem Ofen für das Einkristall-Wachstum gereinigt werden, das Reinigen in einer Raumumgebung durchgeführt wird, in welcher die Reinheitsstufe Klasse 1000 oder mehr beträgt, und ein Silizium-Einkristalls unter Verwendung der Inner-Ofengereinigten Komponenten gewachsen wird.

5. Das Verfahren zur Herstellung eines Silizium-Einkristalls nach Anspruch 4, wobei, wenn die Inner-Ofen Komponenten gereinigt werden, Reinigungswerkzeuge und Gestelle verwendet werden, die kein Cu als Rohstoff enthalten.

## Revendications

1. Appareil pour produire un monocristal de silicium selon la méthode de Czochralski, dans lequel la concentration en Cu dans un composant fait de quartz à utiliser dans une partie dans laquelle une température dans un four pour la croissance du monocristal est de 1 000°C ou plus est de 1 ppb ou moins, et la concentration en Cu dans un composant fait de quartz à utiliser dans une partie dans laquelle une température dans un four pour la croissance du monocristal est inférieure à 1 000°C est de 10 ppb ou moins ; et dans lequel les composants faits de quartz sont des composants HZ constituant l'intérieur du four.

2. Appareil pour la production d'un monocristal de silicium selon la revendication 1, dans lequel les dispositifs et les composants étant exposés dans le four pour la croissance du monocristal ne contiennent pas de Cu en tant que matière première.

3. Appareil pour la production d'un monocristal de silicium selon la revendication 1 ou la revendication 2, dans lequel la concentration en Cu dans une fenêtre d'observation faite de quartz fournie dans le four pour la croissance du monocristal est de 10 ppb ou moins.

4. Procédé pour la production d'un monocristal de silicium par la méthode de Czochralski, comprenant au moins l'un parmi un procédé dans lequel, après que la fusion d'une matière première de silicium soit terminée, elle est laissée pendant 3 heures ou plus à une condition qu'un dispositif de chauffage soit chauffé avec une puissance électrique de 80 % ou plus de la puissance dans la fusion de la matière première et le débit d'un gaz inerte introduit dans le four pour la croissance du monocristal soit le débit dans la croissance du monocristal ou plus, et ensuite, un monocristal de silicium est fait croître ; et un procédé, dans lequel, lorsque les composants dans-le-four dans le four pour la croissance du monocristal sont nettoyés, le nettoyage est effectué dans un environnement dans la pièce dans lequel la propreté est de classe 1 000 ou supérieure, et un monocristal de silicium est fait croître en utilisant les composants dans-le-four nettoyés.

5. Procédé de production d'un monocristal de silicium selon la revendication 4, dans lequel lorsque les composants dans-le-four sont nettoyés, les outils de nettoyage et les gabarits qui ne contiennent pas de Cu en tant que matière première sont utilisés.
